# EUROPÄISCHE PATENTANMELDUNG

(11) **EP 3 839 107 A1**
(43) Veröffentlichungstag der Anmeldung: **23.06.2021**
(21) Anmeldenummer: 19217520.6
(22) Anmeldetag: 18.12.2019
(51) Int. Cl.: C30B 29/06, B23K 26/00, C30B 33/06, G01N 21/88, H01L 21/66

(54) **VERFAHREN ZUR BESTIMMUNG VON DEFEKTDICHTEN IN HALBLEITERSCHEIBEN AUS EINKRISTALLINEM SILIZIUM**

(71) Anmelder: Siltronic AG, 81677 München (DE)
(72) Erfinder: Bauer, Stefan, 84524 Neuötting (DE); Kretschmer, Robert, 09599 Freiberg (DE)
(74) Vertreter: Staudacher, Wolfgang

(57) **Zusammenfassung**

Verfahren zur Bestimmung von Defektdichten in Halbleiterscheiben aus einkristallinem Silizium mittels Laser Scattering Tomography, umfassend das Bestrahlen einer geteilten Halbleiterscheibe mittels eines IR-Lasers entlang eines Abtastwegs parallel zu einer Trennfläche, die einen Winkel von 90° mit einer Oberfläche der Halbleiterscheibe einschließt, gekennzeichnet durch Teilen der Halbleiterscheibe senkrecht zur Oberfläche der Halbleiterscheibe entlang einer Trennlinie mittels thermischem Laserstrahl-Separieren, wobei die Oberfläche der Halbleiterscheibe im Wesentlichen {111}-orientiert ist.

## Beschreibung

Gegenstand der Erfindung ist ein Verfahren zur Bestimmung von Defektdichten in Halbleiterscheiben aus einkristallinem Silizium mittels Laser Scattering Tomography (LST) umfassend das Bestrahlen einer geteilten Halbleiterscheibe mittels eines im infraroten Wellenspektrum arbeitenden Lasers (IR-Laser) entlang eines Abtastwegs parallel zu einer Trennfläche, die einen Winkel von 90° mit einer Oberfläche der Halbleiterscheibe einschließt.

### Stand der Technik / Probleme

Laser Scattering Tomography (LST) ist eine Analysenmethode, um Defektdichten in Halbleiterscheiben aus einkristallinem Silizium zu bestimmen. Das Prinzip der Analysenmethode ist beispielsweise in JP 7-239 308 A beschrieben. Vorrichtungen zur Durchführung der Analysenmethode werden kommerziell angeboten.

Gemäß WO 2018/155 126 A1 kann die Analysenmethode beispielsweise verwendet werden, um Agglomerate von Leerstellen im Kristallgitter zu detektieren. Häufiger wird die Analysenmethode jedoch eingesetzt, um Dichten von bulk micro defects (BMDs) im Kristallgitter zu bestimmen. BMDs können entstehen, wenn Sauerstoff im Kristallgitter präzipitiert. Ein Beispiel für eine solche Anwendung der Analysenmethode ist beispielsweise in JP 2010-48 795 A beschrieben.

Ein Merkmal der Analysenmethode ist, dass die Halbleiterscheibe geteilt wird, um eine Fläche freizulegen, die mit der Oberfläche der Halbleiterscheibe einen Winkel von 90° einschließt. Zum Teilen der Halbleiterscheibe wird üblicherweise ausgenutzt, dass einkristalline Halbleiterscheiben aus Silizium entlang von bestimmten Vorzugsebenen mechanisch gespalten werden können.

In JP 2015-211 045 A ist beschrieben, wie eine [100]-orientierte Halbleiterscheibe aus einkristallinem Silizium mit einem Durchmesser von 300 mm unter Freilegen einer {110}-orientierten Trennfläche mechanisch gespalten werden kann, ungeachtet dessen, dass Atome in einer {111}-orientierten Ebene die kleinste Bindungskraft aufweisen.

In US 2011/095 399 A1 ist offenbart, dass eine Halbleiterscheibe mit (111)-Orientierung auch in Quadrate gespalten werden kann.

Es hat sich herausgestellt, dass ein mechanisches Verfahren zum Erzeugen einer Trennfläche zum Zweck der Präparation einer {111}-orientierten Halbleiterscheibe aus einkristallinem Silizium im Zuge der Anwendung der oben erwähnten Analysenmethode keine Trennfläche mit ausreichender Güte liefert. Wegen der geringeren Bindungskraft neigt das Kristallgitter eher dazu, entlang einer {111}-orientierten Ebene gespalten zu werden, die mit der {111}-orientierten Oberfläche der Halbleiterscheibe einen Winkel von ungefähr 70,5° einschließt.

Aus der beschriebenen Problematik ergab sich die Aufgabenstellung der Erfindung.

Die Aufgabe der Erfindung wird gelöst durch ein Verfahren zur Bestimmung von Defektdichten in Halbleiterscheiben aus einkristallinem Silizium mittels Laser Scattering Tomography, umfassend das Bestrahlen einer geteilten Halbleiterscheibe mittels eines IR-Lasers entlang eines Abtastwegs parallel zu einer Trennfläche, die einen Winkel von 90° mit einer Oberfläche der Halbleiterscheibe einschließt, gekennzeichnet durch
Teilen der Halbleiterscheibe senkrecht zur Oberfläche der Halbleiterscheibe entlang einer Trennlinie mittels thermischem Laserstrahl-Separieren, wobei die Oberfläche der Halbleiterscheibe im Wesentlichen {111}-orientiert ist.

Mit dem Teilen der Halbleiterscheibe wird die Trennfläche geschaffen, die den Winkel von 90° mit der Oberfläche der Halbleiterscheibe einschließt.

Im Wesentlichen {111}-orientiert bedeutet, dass die Oberfläche der Halbleiterscheibe {111}-orientiert ist oder eine {111}-Orientierung mit einer Fehlorientierung von nicht mehr als 2° aufweist.

Die Halbleiterscheibe aus einkristallinem Silizium hat vor dem Teilen vorzugsweise einen Durchmesser von nicht weniger als 150 mm, beispielsweise 300 mm, und eine Dicke von nicht weniger als 600 µm. Die {111}-orientierte Oberfläche der Halbleiterscheibe ist vor dem Teilen der Halbleiterscheibe vorzugsweise in einem glanzgeätzten oder polierten Zustand.

Die Grundzüge des thermischen Laserstrahl-Separierens (TLS) sind beispielsweise in DE 10 2017 202 426 A1 und WO 2007/016 895 A1 beschrieben. Die Methode beinhaltet eine initiale Materialschwächung am oder im Werkstück entlang eines Abschnitts einer Trennlinie. Zu diesem Zweck kann die Oberfläche der Halbleiterscheibe entlang des Abschnitts der Trennlinie mechanisch geritzt oder in diesem Abschnitt eine Materialschwächung mittels Laserablation herbeigeführt werden. Der Abschnitt hat eine Länge von vorzugsweise nicht mehr als 10 mm und nicht weniger als 0,5 mm und befindet sich vorzugsweise am Beginn der Trennlinie, entlang derer die Halbleiterscheibe zu teilen beabsichtigt ist. Die TLS-Operation selbst beinhaltet ein lokales Erhitzen der Halbleiterscheibe entlang der Trennlinie mittels Laserstrahlung gefolgt von einem lokalen Kühlen der Halbleiterscheibe entlang der Trennlinie mittels eines Kühlmediums.

Die Trennlinie, entlang derer die Halbleiterscheibe geteilt wird, folgt vorzugsweise einem Durchmesser der Halbleiterscheibe. Des Weiteren ist bevorzugt, dass die Trennlinie in einer Ebene verläuft, die {110}-orientiert ist oder mit einer {110}-Ebene einen Winkel von 90° einschließt.

Es ist nicht vorgesehen, vor der Bestimmung von Defektdichten mittels Laser Scattering Tomography die nach der TLS-Operation entstandenen Trennflächen zu polieren.

Das erfindungsgemäße Verfahren wird vorzugsweise zur Bestimmung der Dichten von bulk micro defects (BMDs) und von Leerstellen-Agglomeraten wie beispielsweise crystal originated particles (COPs) eingesetzt.

## Patentansprüche

1. Verfahren zur Bestimmung von Defektdichten in Halbleiterscheiben aus einkristallinem Silizium mittels Laser Scattering Tomography, umfassend das Bestrahlen einer geteilten Halbleiterscheibe mittels eines IR-Lasers entlang eines Abtastwegs parallel zu einer Trennfläche, die einen Winkel von 90° mit einer Oberfläche der Halbleiterscheibe einschließt, **gekennzeichnet durch** Teilen der Halbleiterscheibe senkrecht zur Oberfläche der Halbleiterscheibe entlang einer Trennlinie mittels thermischem Laserstrahl-Separieren, wobei die Oberfläche der Halbleiterscheibe im Wesentlichen {111}-orientiert ist.

2. Verfahren nach Anspruch 1, **dadurch gekennzeichnet, dass** die Oberfläche der Halbleiterscheibe {111}-orientiert ist oder mit eine Fehlorientierung von dieser Orientierung aufweist, die nicht mehr als 2° beträgt.

3. Verfahren nach Anspruch 1 oder Anspruch 2, **dadurch gekennzeichnet, dass** die Trennlinie einem Durchmesser der Halbleiterscheibe folgt und in einer Ebene verläuft, die {110}-orientiert ist oder mit einer {110}-Ebene einen Winkel von 90° einschließt.
